(19) **Europäisches Patentamt / European Patent Office / Office européen des brevets**

(11) **EP 2 755 848 B1**

(12) # FASCICULE DE BREVET EUROPEEN

(45) Date de publication et mention de la délivrance du brevet:
**25.11.2015 Bulletin 2015/48**

(21) Numéro de dépôt: **12767056.0**

(22) Date de dépôt: **10.09.2012**

(51) Int Cl.:
**B60L 3/00** *(2006.01)* **B60L 3/04** *(2006.01)*
**G01R 31/36** *(2006.01)* **H02M 1/12** *(2006.01)*
**H02J 7/02** *(2006.01)* **B60L 11/18** *(2006.01)*
**H02J 7/00** *(2006.01)* **H01M 8/04** *(2006.01)*
**G01R 31/02** *(2006.01)* **H01M 10/44** *(2006.01)*
**H01M 10/48** *(2006.01)*

(86) Numéro de dépôt international:
**PCT/FR2012/052019**

(87) Numéro de publication internationale:
**WO 2013/038098 (21.03.2013 Gazette 2013/12)**

(54) **PROCEDE DE SURVEILLANCE DU FILTRE CAPACITIF D'UN CHARGEUR DE BATTERIE**

VERFAHREN ZUR ÜBERWACHUNG DES KAPAZITIVEN FILTERS EINES BATTERIELADEGERÄTES

METHOD OF MONITORING THE CAPACITIVE FILTER OF A BATTERY CHARGER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.09.2011 FR 1158163**

(43) Date de publication de la demande:
**23.07.2014 Bulletin 2014/30**

(73) Titulaire: **Renault S.A.S.**
**92100 Boulogne-Billancourt (FR)**

(72) Inventeur: **MALRIEU, Julien**
**78280 Guyancourt (FR)**

(56) Documents cités:
**CN-A- 101 599 656     FR-A1- 2 943 188**
**US-A- 4 419 621     US-A- 5 880 589**
**US-A1- 2006 072 352     US-A1- 2010 321 038**

Printed by Jouve, 75001 PARIS (FR)

**Description**

L'invention concerne les moyens de filtrage du courant d'entrée d'un dispositif de charge de batterie haute tension, notamment d'un véhicule automobile à traction électrique, à partir d'un réseau d'alimentation monophasé ou triphasé, et plus particulièrement la surveillance de l'état des moyens de filtrage.

Dans des systèmes de recharge de batterie à haute tension, la puissance électrique du réseau est amenée à la batterie successivement au travers de deux convertisseurs : un abaisseur de tension (« buck ») et un élévateur de tension (« boost »). Ces deux convertisseurs permettent respectivement d'abaisser et d'élever le rapport de tension entre leur borne de sortie et leur borne d'entrée, en ouvrant et en fermant successivement une série d'interrupteurs, à une fréquence qui est commandée en fonction du courant de sortie, et/ou de la tension de sortie souhaitée.

De tels systèmes de recharge sont par exemple décrits dans la demande de brevet FR 2 943 188 qui porte sur un système de recharge embarqué pour véhicule automobile, permettant un rechargement à partir d'un circuit triphasé ou monophasé d'une batterie du véhicule, le circuit de recharge intégrant les bobines d'une machine électrique qui assure par ailleurs d'autres fonctions comme la génération de courant ou la propulsion du véhicule. Les préambules des revendications 1 et 10 sont basées sur ce document.

Le hachage du courant tiré du réseau d'alimentation induit des composantes à haute fréquence dans le courant prélevé, c'est-à-dire des harmoniques d'ordre supérieur au fondamental du réseau de distribution qui est classiquement à 50 Hz.

Les fournisseurs d'énergie électrique imposant une norme sur les harmoniques du courant prélevé, un tel système de recharge comporte également des moyens de filtrage de type RLC (Résistif-Inductif-Capacitif) à l'entrée de l'abaisseur de tension.

Les moyens de filtrage comprennent généralement un filtre de compatibilité électromagnétique (CEM), ainsi qu'un filtre de type capacitif comportant des capacités de filtrage disposées « en étoile » de manière à effectuer un filtrage entre chaque phase du réseau de distribution. Le filtre CEM est, par exemple, un filtre à inductances et à capacités de mode commun permettant de filtrer les impulsions de courant générées par les transistors de l'étage abaisseur de tension et de l'étage élévateur de tension du système de recharge. Les moyens de filtrage permettent ainsi de filtrer le courant absorbé de sorte que le courant satisfasse aux contraintes de raccordement au réseau imposées par les exploitants de réseaux, en termes d'harmoniques ainsi que celles du domaine automobile.

Dans la configuration prenant en compte le neutre, le filtre capacitif comprend également une capacité de filtrage du neutre disposée entre le fil du neutre et le point commun des capacités de filtrage. Cette dernière capacité permet d'effectuer un filtrage entre le fil du neutre et les phases.

Cependant, un tel filtre capacitif peut se dégrader, par exemple dans le cas d'une dégradation ou d'un vieillissement d'une ou plusieurs capacités. Une telle dégradation du filtre capacitif peut alors entraîner une inefficacité de filtrage et un déséquilibre du réseau de distribution.

Pour surveiller le filtre capacitif, on peut se référer au document US 4 419 621 qui décrit un système réalisant une surveillance d'un filtre capacitif couplé à une batterie. Le système de surveillance utilise une analyse fréquentielle des signaux. Cependant, un tel dispositif présente une complexité élevée pour une simple détection de défaut.

On connaît également du document US 5 880 589 un dispositif permettant de réaliser un diagnostique d'une capacité électrolytique en fonctionnement.

On pourra également se référer au document US 2010/0321038 qui décrit l'utilisation d'une équation spécifique permettant de calculer précisément la valeur de chaque capacité du système. Cependant, un tel dispositif présente également une complexité élevée pour une simple détection de défaut, et un prix de revient élevé.

L'invention vise à pallier les inconvénients mentionnés ci-dessus en proposant un dispositif selon la revendication 1 et un procédé de surveillance simple et peu couteux selon la revendication 10, permettant de détecter une éventuelle déviation d'une ou plusieurs des capacités du filtre capacitif couplé à un réseau monophasé ou triphasé de manière à réduire les performances de charge et à informer l'utilisateur que le filtre capacitif doit être remplacé, voire même à interdire la charge de la batterie du véhicule électrique si cette détérioration est très importante.

Selon un aspect, il est proposé, dans un mode de réalisation, un dispositif de charge d'une batterie, notamment une batterie d'un véhicule automobile à traction électrique, à partir d'un réseau d'alimentation triphasé ou monophasé, comprenant un étage de filtrage comportant un ensemble capacitif et destiné à être raccordé au réseau d'alimentation. Dans un mode de réalisation, le dispositif peut comporter un étage abaisseur de tension raccordé à l'étage de filtrage, et un étage élévateur de tension destiné à être raccordé à la batterie et couplé à l'étage abaisseur de tension.

Selon une caractéristique générale, le dispositif comprend des moyens de surveillance de l'ensemble capacitif apte à détecter une déviation de la valeur de la capacité d'au moins une capacité de l'ensemble capacitif à partir de tensions et de courants mesurés en entrée de l'étage de filtrage.

De préférence, les moyens de surveillance comprennent des moyens de détermination de valeurs caractéristiques des tensions et des courants mesurés, des moyens de calcul d'au moins un paramètre représentatif de l'ensemble capacitif à partir de ces valeurs caractéristiques de tension et de courant, des moyens de détermination de l'état des condensateurs de l'ensemble capacitif à partir du paramètre représentatif calculé, et des moyens de traitement aptes à délivrer un signal de commande et/ou un signal d'avertissement de manière à avertir l'utilisateur de la dégradation de l'ensemble capacitif.

Les valeurs caractéristiques des tensions et des courants peuvent être par exemple les valeurs efficaces de ces tensions et courants.

Dans un mode de réalisation, le signal de commande est capable de provoquer une limitation des performances de charge de la batterie.

Avantageusement, les moyens de détermination de l'état des condensateurs peuvent comprendre au moins un module de calcul apte à calculer la valeur absolue de la différence entre le paramètre représentatif et une constante capacitive, et au moins un module de comparaison apte à comparer ladite valeur absolue calculée à un seuil de variation.

Les moyens de surveillance peuvent également comprendre des moyens d'activation aptes à activer les moyens de surveillance lorsque le dispositif est raccordé au réseau d'alimentation et avant le début de la charge de la batterie, le paramètre représentatif étant proportionnel, lorsque les moyens de surveillance sont activés avant le début de la charge de la batterie, au rapport entre la valeur du courant efficace d'une première phase et le produit de la fréquence avec la valeur de la tension efficace entre la première phase et une autre phase.

De préférence, les moyens de surveillance peuvent comprendre des moyens d'activation en charge aptes à activer les moyens de surveillance lorsque la batterie est en charge sur un réseau d'alimentation monophasé, le paramètre représentatif correspondant, lorsque les moyens de surveillance sont activés après le début d'une charge sur un réseau monophasé, au rapport entre, d'une part, la différence entre le double du carré de la valeur efficace du courant d'alimentation et le carré de la valeur efficace du courant en entrée de l'étage abaisseur de tension, et, d'autre part, le produit de la tension efficace aux bornes du réseau d'alimentation et de la fréquence du réseau d'alimentation.

Selon un autre aspect, il est proposé un véhicule automobile à traction au moins partiellement électrique, comprenant une machine électrique couplée à des roues motrices et un étage onduleur apte à alimenter la machine électrique à partir d'une batterie, caractérisé en ce qu'il comprend un dispositif de charge de la batterie tel que défini ci-dessus.

Selon un autre aspect, il est proposé, dans un mode de mise en oeuvre, un procédé de commande d'un dispositif de charge d'une batterie, notamment une batterie d'un véhicule automobile à traction électrique, à partir d'un réseau d'alimentation triphasé ou monophasé, dans lequel on filtre au moins une tension d'entrée issue dudit réseau d'alimentation à l'aide d'un étage de filtrage comprenant un ensemble capacitif, on mesure le courant d'alimentation en entrée de l'étage de filtrage, et l'on mesure la tension d'alimentation en entrée de l'étage de filtrage.

Selon une caractéristique générale, on surveille l'état des condensateurs de l'ensemble capacitif à partir de la variation d'au moins un paramètre représentatif de l'ensemble capacitif à partir des tensions et des courants mesurés en entrée de l'étage de filtrage.

De préférence, le procédé comprend une détermination des valeurs efficaces des tensions et des courants mesurés, un calcul d'au moins un paramètre représentatif de l'ensemble capacitif à partir des valeurs efficaces de tension et de courant, et une détermination de l'état des condensateurs de l'ensemble capacitif à partir du paramètre représentatif ainsi calculé, et une délivrance d'un signal de commande pour limiter les performances de charge de la batterie et d'un signal d'avertissement de manière à avertir l'utilisateur de la dégradation de l'ensemble capacitif.

La détermination de l'état des condensateurs de l'ensemble capacitif peut avantageusement comprendre au moins un calcul de la valeur absolue de la différence entre une constante capacitive et un desdits paramètres représentatifs de l'ensemble capacitif, et une comparaison du résultat de la soustraction calculée à un seuil de variation.

De préférence, le paramètre représentatif correspond, lorsque les moyens de surveillance sont activés avant le début de la charge de la batterie, au rapport entre la valeur du courant efficace d'une première phase et le produit de la fréquence avec la valeur de la tension efficace entre la première phase et une autre phase et, lorsque les moyens de surveillance sont activés après le début d'une charge sur un réseau monophasé, au rapport entre, d'une part, la différence entre deux fois le carré de la valeur efficace du courant d'alimentation et le carré de la valeur efficace du courant en entrée de l'étage abaisseur de tension, et, d'autre part, le produit de la tension efficace aux bornes du réseau d'alimentation et la fréquence du réseau d'alimentation.

D'autres avantages et caractéristiques de l'invention apparaîtront à l'examen de la description détaillée d'un mode de mise en oeuvre et d'un mode de réalisation, nullement limitatifs, et des dessins annexés, sur lesquels :

- la figure 1 représente de manière schématique un dispositif de charge d'une batterie d'un véhicule automobile selon un mode de réalisation ;
- la figure 2 illustre, de manière plus détaillée, un mode de réalisation du dispositif de charge de la figure 1 ;
- la figure 3 illustre de manière plus détaillée les moyens de surveillance du dispositif de charge de la figure 1 ;
- la figure 4 présente un organigramme d'un procédé de commande du dispositif de charge selon un mode de mise en oeuvre.

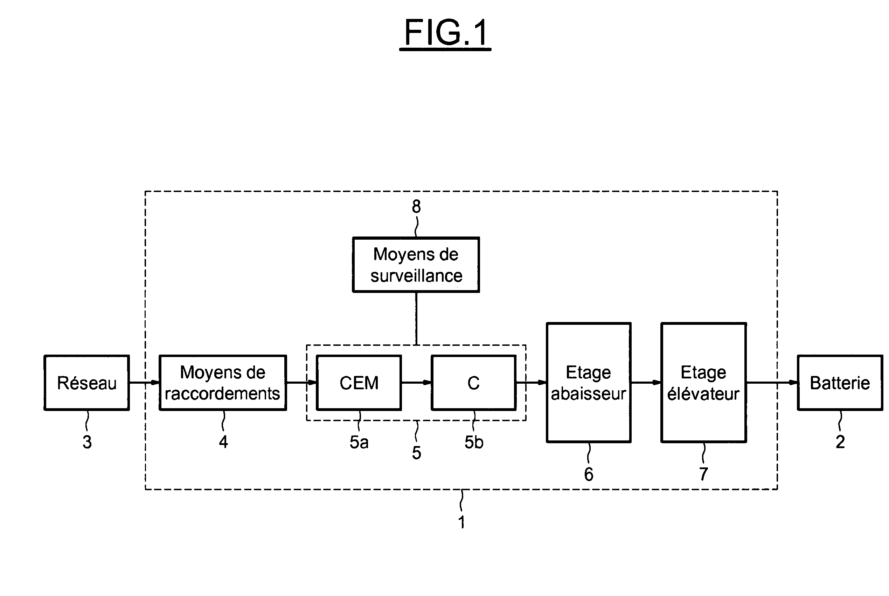

Sur la figure 1, est représenté, de manière schématique, un dispositif 1 de charge d'une batterie 2 d'un véhicule automobile destiné à être raccordé à un réseau d'alimentation 3 triphasé ou monophasé pour recharger la batterie 2.

Le dispositif 1 comprend des moyens de raccordement 4 permettant de raccorder le dispositif 1 de charge au réseau d'alimentation 3, un étage de filtrage 5 permettant de filtrer le courant du réseau d'alimentation 3 prélevé par le dispositif 1, un étage abaisseur de tension 6 raccordé à la sortie de l'étage de filtrage 5 et permettant de redresser le courant alternatif issu du réseau d'alimentation 3, ainsi qu'un étage élévateur de tension 7 couplé entre l'étage abaisseur de tension 6 et la batterie 2.

Les moyens de filtrage 5 comprennent un filtre 5a de compatibilité électromagnétique (CEM), ainsi qu'un ensemble capacitif 5b. Le filtre 5a CEM est, par exemple, un filtre à inductances et à capacités de mode commun permettant de filtrer les impulsions de courant générées par les transistors des étages abaisseur de tension 6 et élévateur de sortie 7 du dispositif 1. Les moyens de filtrage 5 permettent de filtrer le courant ainsi absorbé de sorte que le courant satisfasse aux contraintes de raccordement au réseau imposées par les exploitants de réseaux, en termes d'harmoniques ainsi que celles du domaine automobile.

L'ensemble capacitif 5b comprend des capacités couplées selon une disposition dite « en étoile » de manière à avoir deux capacités couplées entre chaque phase. Au lieu d'une disposition des capacités dite « en étoile », il est également possible de disposer les capacités 5b selon une disposition dite « en triangle » (non représentée), c'est-à-dire en disposant les capacités entre chaque phase et le neutre à la sortie des moyens de filtrage 5a CEM. On diminue ainsi la valeur de courant qui les traverse.

Le dispositif 1 comprend également des moyens de surveillance 8 de l'ensemble capacitif 5b aptes à détecter une déviation de la valeur d'au moins une capacité de l'ensemble capacitif 5b.

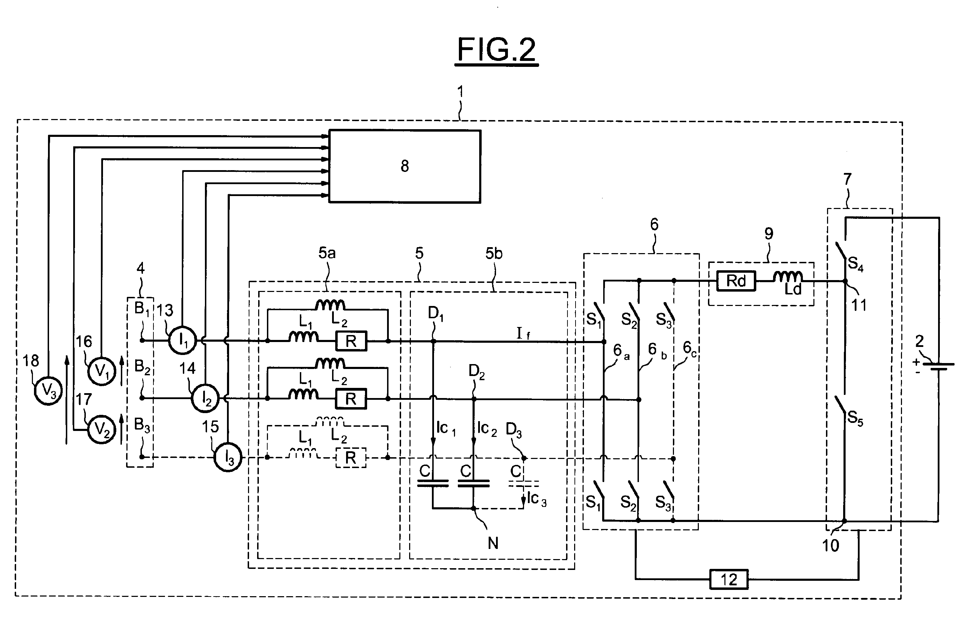

Sur la figure 2 est illustré de manière plus détaillée le dispositif de charge de la figure 1.

L'étage élévateur de tension 7 est raccordé à l'étage abaisseur de tension 6 via un élément inductif 9 symbolisé sur la figure par une résistance Rd disposée en série avec une bobine d'induction Ld.

Le dispositif 1 pouvant être couplé à une alimentation aussi bien triphasée que monophasée, les moyens de raccordement 4 comprennent trois bornes $B_1$, $B_2$, $B_3$ couplées en entrée de l'étage de filtrage 5, et aptes à être couplées au réseau d'alimentation 3. En recharge triphasé, les trois bornes $B_1$, $B_2$, $B_3$ sont couplées à un réseau d'alimentation triphasé. En recharge monophasée, seules les entrées $B_1$ et $B_2$ sont couplées à un réseau d'alimentation monophasé délivrant une tension d'entrée $V_1$ et un courant d'entrée $I_1$. Chaque borne d'entrée $B_1$, $B_2$ et $B_3$ est raccordée à une branche de filtrage du filtre CEM 5a. Chaque branche de filtrage du filtre CEM 5a comprend deux branches en parallèle, portant l'une une inductance de valeur $L_2$ et l'autre portant en série une inductance de valeur $L_1$ et une résistance de valeur R.

Ces deux branches de filtrage sont chacune couplées en sortie à un condensateur de capacité C de l'ensemble capacitif 5b également couplé à la masse, en des points respectivement nommés $D_1$, $D_2$, $D_3$ pour chacune des branches de filtrage du filtre CEM 5a. Les différents condensateurs de capacité C sont tous reliés à un point commun ou point neutre noté N sur la figure 2. L'ensemble des résistances de valeurs R. des inductances de valeurs $L_1$ ou $L_2$, et des condensateurs de capacité C constitue un filtre de type RLC à l'entrée de l'abaisseur de tension 3.

En recharge monophasée, la borne $B_3$ n'est pas couplée au réseau d'alimentation. La branche couplée à la borne $B_3$ n'étant considérée que dans le cas d'une recharge triphasée, celle-ci a été représentée en pointillés. Les autres éléments du circuit électrique représentés en pointillés sont des éléments qui ne sont utilisés que dans le cadre d'un couplage à un réseau d'alimentation triphasé.

L'étage abaisseur de tension 6 est couplé à l'étage de filtrage 5 par les points $D_1$, $D_2$ et $D_3$. Celui-ci comprend trois branches parallèles 6a. 6b et 6c portant chacune deux interrupteurs $S_1$, $S_2$ ou $S_3$ commandés par une unité de commande 12.

Les extrémités communes des branches 6, 7 et 8 constituent deux bornes de sortie de l'abaisseur de tension 6. L'une des bornes est reliée à la borne « - » de la batterie 2 ainsi qu'à une première entrée 10 de l'étage élévateur de tension 7. L'autre de ces bornes est connectée à une première borne de la machine électrique 9, dont l'autre borne est connectée à une seconde entrée 11 de l'élévateur de tension 7.

L'étage élévateur de tension 7 comprend deux interrupteurs $S_4$ et $S_5$ pilotables par l'unité de commande 12 de manière indépendante. Ces deux interrupteurs $S_4$ et $S_5$ sont situés sur une branche reliant la première entrée 10 de l'étage élévateur de tension 7 et la borne « + » de la batterie 2. La seconde entrée 11 de l'étage élévateur de tension 7, à laquelle est connectée la machine électrique 9, est connectée entre les deux interrupteurs $S_4$ et $S_5$, l'interrupteur $S_4$ étant couplé entre la seconde entrée 11 et la borne « + » de la batterie 2, et l'interrupteur $S_5$ étant couplé entre la première entrée 10 et la seconde entrée 11.

Le dispositif 1 comprend un premier capteur de courant 13, un second capteur de courant 14, et un troisième capteur de courant 15 aptes à mesurer respectivement le courant $I_1$ circulant sur la branche couplée à la première borne $B_1$, le courant $I_2$ circulant sur la branche couplée à la seconde borne $B_2$, et le courant $I_3$ circulant sur la branche couplée à la troisième borne $B_3$.

Le dispositif comprend également un premier capteur de tension 16, un second capteur de tension 17, et un troisième capteur de tension 18 aptes à mesurer respectivement la tension $V_1$ entre la première borne $B_1$ et la seconde borne $B_2$, la tension $V_2$ entre la seconde borne $B_2$ et la troisième borne $B_3$, et la tension $V_3$ entre la première borne $B_1$ et la troisième borne $B_3$.

Les capteurs de tension 16 à 18, et les capteurs de courant 13 à 15 sont couplés au moyen de surveillance 8 du dispositif. Dans le cas d'une recharge sur un réseau d'alimentation monophasé, seule la mesure du premier capteur de courant 13 et la mesure du premier capteur de tension 16 sont utilisées pour surveiller l'état des condensateurs de capacité C de l'ensemble capacitif 5b. On notera que la mesure du capteur de courant 14 peut être utilisée à la place de la mesure du capteur de courant 13 en cas de défaillance de ce dernier.

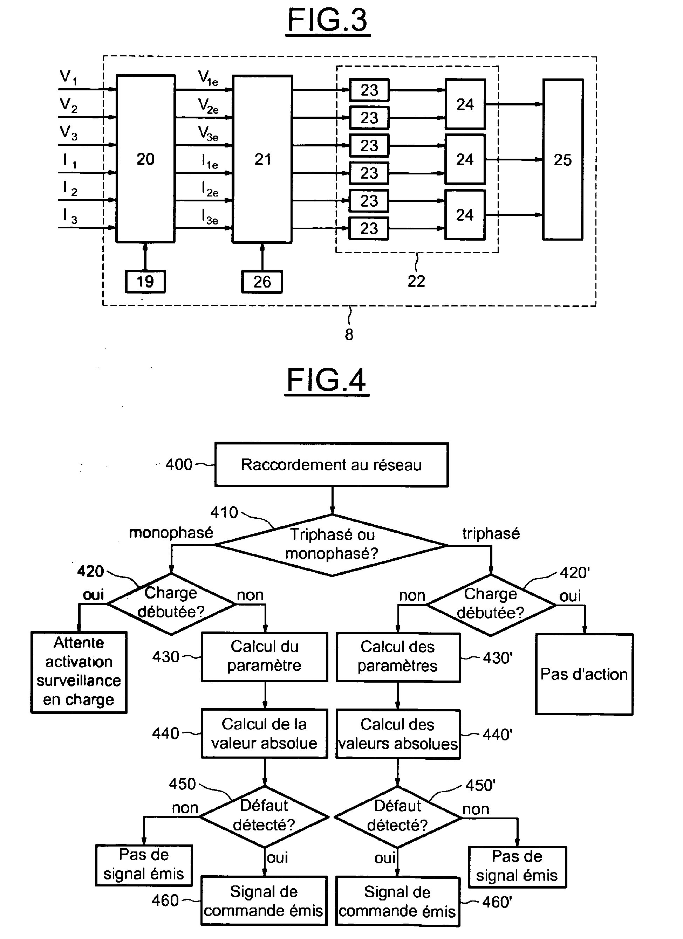

Sur la figure 3 sont illustrés de manière plus détaillée les moyens de surveillance 8 du dispositif 1 de charge d'une batterie 2 de la figure 1.

Les moyens de surveillance 8 comprennent des moyens d'activation 19 aptes à activer les moyens de surveillance 8 lorsque le dispositif est raccordé au réseau d'alimentation 3 et avant que la charge n'ait débuté.

Les moyens de surveillance 8 comprennent des moyens 20 de détermination des valeurs efficaces recevant en entrée les valeurs des tensions $V_1$, $V_2$, $V_3$ mesurées respectivement par les premier, second et troisième capteurs de tension 16, 17, 18 et les intensités des courants $I_1$, $I_2$, $I_3$ mesurées respectivement par les premier, second et troisième capteurs de courant 13, 14, 15. Les moyens 20 de détermination des valeurs efficaces délivrent en sortie les valeurs efficaces $V_{1e}$, $V_{2e}$, $V_{3e}$ des tensions $V_1$, $V_2$, $V_3$ ainsi que les valeurs efficaces $I_{1e}$, $I_{2e}$, $I_{3e}$ des courants $I_1$, $I_2$, $I_3$.

Les moyens d'activation 19 sont raccordés aux moyens 20 de détermination de sorte que dès qu'une mesure de courant correspondant au raccordement d'un réseau d'alimentation 3 au dispositif de charge 1 est délivrée par l'un des capteurs de courant 13 à 15 aux moyens de détermination 20, les moyens d'activation activent les moyens 20 de détermination.

Les moyens de surveillance 8 comprennent des moyens de calcul 21 d'au moins un paramètre représentatif de l'ensemble capacitif 5b couplés en sortie à des moyens de détermination 22 de l'état des condensateurs de capacité C de l'ensemble capacitif 5b à partir des paramètres représentatifs calculés.

Les moyens de calcul 21 reçoivent en entrées les valeurs efficaces de tension $V_{1e}$, $V_{2e}$, $V_{3e}$ et de courant $I_{1e}$, $I_{2e}$, $I_{3e}$, et calculent pour chaque phase, c'est-à-dire pour chaque branche couplée à une borne $B_1$, $B_2$ ou $B_3$, au moins un paramètre représentatif de l'ensemble capacitif 5b.

Dans le cas où le dispositif de charge 1 est raccordé à un réseau d'alimentation 3 triphasé, les moyens de surveillance 8 sont activés avant le début de charge de la batterie 2 par les moyens d'activation 19. On a alors $I_1 = I_{c1}$, $I_2 = I_{c2}$, $I_3 = I_{c3}$ (voir notamment figure 2). L'ensemble capacitif 5b constituant un système équilibré, c'est-à-dire que les capacités couplées entre deux phases ont la même valeur que les capacités couplées entre chaque autre paire de phases, la relation suivante est vérifiée pour chaque phase :

$$\frac{I_e}{f \cdot V_e} = k \cdot \pi \cdot C = cst$$

Avec $f$ la fréquence (mesurée) du courant distribuée par le réseau d'alimentation 3, $I_e$ la valeur efficace du courant d'une phase (c'est à dire $I_{e1}$, $I_{e2}$, ou $I_{e3}$), $V_e$ la valeur efficace de la tension entre deux phases comprenant cette phase, $k$ un coefficient dépendant du filtre CEM 5a, et C la valeur de la capacité équivalente couplée entre les deux phases. Dans un système équilibré, toutes les capacités étant égales, le terme $k\pi C$ est constant à moins qu'une capacité soit mise en défaut. Le terme $k\pi C$ est nommé par la suite constante capacitive. Ce terme est obtenu par calibration dans une étape préliminaire.

Pour contrôler l'état de la capacité couplée entre la première phase sur laquelle circule le courant $I_1$ et le point neutre, les moyens de calcul 21 calculent la paire de paramètres représentatifs suivants :

$$\frac{I_{1e}}{f \cdot V_{1e}} \quad \text{et} \quad \frac{I_{1e}}{f \cdot V_{3e}}$$

De la même manière, pour contrôler l'état de la capacité couplée entre la seconde phase sur laquelle circule le courant $I_2$ et la masse, les moyens de calcul 21 calculent la paire de paramètres représentatifs suivants :

$$\frac{I_{2e}}{f \cdot V_{2e}} \quad \text{et} \quad \frac{I_{2e}}{f \cdot V_{1e}}$$

Et pour contrôler l'état de la capacité couplée entre la troisième phase sur laquelle circule le courant $I_3$ et le

point neutre, les moyens de calcul 21 calculent la paire de paramètres représentatifs suivants :

$$\frac{I_{3e}}{f \cdot V_{3e}} \quad \text{et} \quad \frac{I_{3e}}{f \cdot V_{2e}}$$

Les trois paires de paramètres représentatifs de l'état de l'ensemble capacitif 5b sont transmis aux moyens de détermination 22 de l'état des capacités C de l'ensemble capacitif 5b. L'utilisation d'une paire de paramètres représentatifs par phase permet de déterminer quelle capacité de l'ensemble capacitif 5b est défaillante.

Les moyens de détermination 22 comprennent pour chaque paramètre représentatif reçu un module de calcul 23 délivrant en sortie la valeur absolue du résultat de la différence entre le paramètre représentatif et la constante capacitive $k\pi C$, soit :

$$\left| \frac{I_e}{f \cdot V_e} - k \cdot \pi \cdot C \right|$$

Pour chaque phase, on obtient ainsi une paire de valeurs absolues délivrée à un comparateur 24. Chaque valeur absolue de la paire est comparée à un seuil de variation. Si au moins une valeur absolue du résultat est supérieure au seuil de variation, la capacité C couplée entre la phase et le point neutre est dégradée.

Les trois comparateurs 24 sont couplés en sortie à un module de traitement 25 capable de délivrer en sortie un signal de commande pour limiter les performances de charge de la batterie 2 et un signal d'avertissement de manière à avertir l'utilisateur de la dégradation de l'ensemble capacitif 5b et de la nécessité de procéder à son changement.

Dans le cas où le dispositif de charge 1 est raccordé à un réseau d'alimentation 3 monophasé par les bornes $B_1$ et $B_2$, un seul paramètre représentatif est calculé par les moyens de calcul 21 :

$$\frac{I_{1e}}{f \cdot V_{1e}}$$

Ce paramètre représentatif est délivré par les moyens de calcul 21 à un module de calcul 23 pour calculer la valeur absolue :

$$\left| \frac{I_{1e}}{f \cdot V_{1e}} - k \cdot \pi \cdot C \right|$$

La valeur absolue ainsi calculée est délivrée à un comparateur 24 de manière à être comparée au seuil de variation. Si la valeur absolue est inférieure au seuil de variation, les condensateurs de capacité C couplés en entre les deux phases ne sont pas considérés comme dégradées. Sinon un signal est délivré au module de traitement 25 pour commander une limitation de la charge et l'avertissement de l'utilisateur.

Dans le cas où le dispositif est raccordé à un réseau d'alimentation 3 monophasé, il est également possible de réaliser une surveillance alors que la batterie 2 est en charge. Pour cela, les moyens de surveillance comprennent un module d'activation en charge 26 apte à commander les moyens de calcul 21.

Dans le cas où la batterie 2 est en charge, la relation suivante est vérifiée :

$$\vec{I} = \vec{I_f} + \frac{C}{2} \cdot \frac{\partial \vec{U_c}}{\partial t}$$

Avec $I_f$ le courant circulant entre le point $D_1$ et l'étage abaisseur de tension 6, et $U_c$ la tension aux bornes des deux capacités couplées entre les bornes $B_1$ et $B_2$. L'unité de commande 12 pilote la charge de la batterie de telle manière que $U_c$ et $I_f$ soient en phase. $I_f$ étant piloté, sa valeur est connue et correspond à une donnée logicielle.

Le courant $I_f$ et la tension $U_c$ étant en phase, la relation précédente peut s'écrire :

6

$$\overline{I} \cdot \sin(\omega t - \varphi) = \overline{I_f} \cdot \sin(\omega t) + \frac{\omega C k V_1}{2} \cos(\omega t)$$

$\varphi$ étant un déphasage dû au filtre CEM et avec l'approximation : $U_c = kV_1$.

En considérant les valeurs efficaces de courant et de tension, on peut en déduire l'expression suivante :

$$C^2 \pi^2 k^2 f^2 = \frac{2I_{1e}^2 - I_{fe}^2}{V_{1e}^2}$$

Avec $f$ la fréquence du courant distribuée par le réseau d'alimentation 3 monophasé, $I_{1e}$ la valeur efficace du courant en entrée des moyens de filtrage 5, $V_{1e}$ la valeur efficace de la tension entre les deux bornes B$_1$ et B$_2$, et $k$ un coefficient dépendant du filtre CEM 5a.

Pour surveiller l'état de l'ensemble capacitif 5b lors d'une charge depuis un réseau d'alimentation 3 monophasé, les moyens de calcul 21 activés par le module d'activation en charge 26 calculent le paramètre représentatif suivant :

$$\frac{2I_{1e}^2 - I_{fe}^2}{V_{1e}^2}$$

Ce paramètre représentatif est alors délivré à un module de calcul 23 qui calcule la valeur absolue suivante :

$$\left| \frac{2I_{1e}^2 - I_{fe}^2}{V_{1e}^2} - C^2 \pi^2 k^2 f^2 \right|$$

La valeur absolue ainsi calculée est délivrée à un comparateur 24 pour être comparée à un seuil de variation. Si la valeur absolue est supérieure au seuil de variation, une des capacités C couplées entre les deux bornes B$_1$ et B$_2$ est dégradée.

Lorsqu'une dégradation d'une capacité est ainsi détectée par au moins un comparateur 24, le module de traitement 25 délivre en sortie un signal de commande pour limiter les performances de charge de la batterie 2 et un signal d'avertissement de manière à avertir l'utilisateur de la dégradation de l'ensemble capacitif 5b et de la nécessité de procéder à son changement.

Sur la figure 4 est représenté de manière schématique un organigramme d'un procédé de commande d'un dispositif de charge (1) selon un mode de mise en oeuvre.

Dans une première étape 400 on détecte le raccordement du dispositif de charge à un réseau d'alimentation 3 grâce aux mesures de courant et de tension aux bornes d'entrée B$_1$, B$_2$, B$_3$ du dispositif 1 réalisées par les capteurs de courant 13 à 15 et les capteurs de tension 16 à 18.

Dans une étape suivante 410, on détermine à partir des mesures de tension et de courant si le réseau d'alimentation raccordé 3 est un réseau d'alimentation monophasé est triphasé ou monophasé.

Dans une étape suivante 420 dans le cas d'un réseau monophasé et 420' dans le cas d'un réseau triphasé, on détermine si la charge de la batterie 2 a débuté. Si elle n'a pas commencée, on active, dans une étape suivante 430 dans le cas d'un réseau monophasé et 430' dans le cas d'un réseau triphasé, les moyens de surveillance 8 et on calcule un paramètre représentatif si le réseau d'alimentation est monophasé 3, et trois paires de paramètres représentatifs si le réseau d'alimentation 3 est triphasé.

Dans une étape suivante 440, dans le cas d'un réseau monophasé et 440' dans le cas d'un réseau triphasé, on calcule la valeur absolue de la différence entre le ou les paramètres représentatifs et la constante capacitive.

Dans une étape suivante 450, dans le cas d'un réseau monophasé et 450' dans le cas d'un réseau triphasé, on détecte l'existence d'une dégradation d'un condensateur à partir de la comparaison de la ou des valeurs absolues calculées à un seuil de variation.

Dans le cas d'un réseau monophasé, si la valeur absolue calculée est supérieure au seuil de variation, alors, dans une étape suivante 460, un condensateur au moins de l'ensemble capacitif 5b est dégradé et un signal de commande est délivré pour limiter les performances de charge de la batterie 2. Un signal d'avertissement est délivré de manière à avertir l'utilisateur de la dégradation de l'ensemble capacitif 5b.

Dans le cas d'un réseau triphasé, si au moins une valeur absolue d'une paire de paramètres représentatifs est supérieure au seuil de variation, alors le condensateur de l'ensemble capacitif 5b couplé entre la phase considérée et le point neutre est dégradé. Dans une étape suivante 460', un signal de commande est délivré pour limiter les performances de charge de la batterie 2 et un signal d'avertissement est délivré de manière à avertir l'utilisateur de la dégradation de l'ensemble capacitif 5b.

Si aucun défaut n'est détecté aucun signal n'est émis.

Si dans l'étape 420, on détecte que la charge de la batterie 2 a déjà débuté, on attend l'activation de la surveillance en charge par les moyens d'activation en charge 26. Dans le cas d'un raccordement à un réseau d'alimentation triphasé (étape 420'), on ne réalise pas de surveillance en charge.

L'invention propose ainsi un dispositif et un procédé de surveillance simples et peu coûteux, permettant de détecter une éventuelle déviation d'une ou plusieurs des capacités du filtre capacitif couplé à un réseau monophasé ou triphasé de manière à réduire les performances de charge et à informer l'utilisateur que le filtre capacitif doit être remplacé, voire même à interdire la charge de la batterie du véhicule électrique si cette détérioration est très importante.

## Revendications

1. Dispositif (1) de charge d'une batterie (2), notamment une batterie d'un véhicule automobile à traction électrique, à partir d'un réseau d'alimentation (3) triphasé ou monophasé, comprenant un étage de filtrage (5) comportant un ensemble capacitif (5b) et destiné à être raccordé au réseau d'alimentation (3), **caractérisé en ce qu'**il comprend des moyens de surveillance (8) de l'ensemble capacitif (5b) aptes à détecter une déviation de la valeur de la capacité d'au moins une capacité (C) de l'ensemble capacitif (5b) à partir de tensions et de courants mesurés en entrée ($B_1$, $B_2$, $B_3$) de l'étage de filtrage (5).

2. Dispositif selon la revendication 1, comportant en outre un étage abaisseur de tension (6) raccordé à l'étage de filtrage (5), et un étage élévateur de tension (7) destiné à être raccordé à la batterie (2) et couplé à l'étage abaisseur de tension (6).

3. Dispositif (1) selon l'une des revendications 1 ou 2, **caractérisé en ce que** les moyens de surveillance (8) comprennent des moyens (20) de détermination de valeurs caractéristiques des tensions et des courants mesuré, des moyens de calcul (21) d'au moins un paramètre représentatif de l'ensemble capacitif à partir desdites valeurs caractéristiques de tension et de courant, des moyens de détermination (22) de l'état des condensateurs de l'ensemble capacitif (5b) à partir du paramètre représentatif, et des moyens de traitement (25) aptes à délivrer un signal de commande et/ou un signal d'avertissement de manière à avertir l'utilisateur de la dégradation de l'ensemble capacitif (5b).

4. Dispositif selon la revendication 3, dans lequel les valeurs caractéristiques sont les valeurs efficaces.

5. Dispositif selon l'une des revendications 3 ou 4, dans lequel le signal de commande est capable de limiter les performances de charge de la batterie.

6. Dispositif (1) selon l'une des revendications 3 à 5, **caractérisé en ce que** les moyens de détermination (22) de l'état des condensateurs comprennent au moins un module de calcul (23) apte à calculer la différence entre le paramètre représentatif et une constante capacitive, et au moins un module de comparaison (24) apte à comparer ladite différence calculée à un seuil de variation.

7. Dispositif (1) selon l'une des revendications précédentes, dans lequel les moyens de surveillance (8) comprennent des moyens d'activation (19) aptes à activer les moyens de surveillance (8) lorsque le dispositif (1) est raccordé au réseau d'alimentation (3) et avant le début de la charge de la batterie (2), le paramètre représentatif étant proportionnel, lorsque les moyens de surveillance (8) sont activés avant le début de la charge de la batterie (2), au rapport entre la valeur du courant efficace d'une première phase et le produit de la fréquence avec la valeur de la tension efficace entre la première phase et une autre phase.

8. Dispositif (1) selon l'une des revendications précédentes, dans lequel les moyens de surveillance (8) comprennent des moyens d'activation en charge (26) aptes à activer les moyens de surveillance (8) lorsque la batterie (2) est en charge sur un réseau d'alimentation (3) monophasé, le paramètre représentatif correspondant, lorsque les moyens de surveillance (8) sont activés après le début d'une charge sur un réseau d'alimentation (3) monophasé, au rapport entre, d'une part, la différence entre le double du carré de la valeur efficace du courant d'alimentation et le carré de la valeur efficace du courant en entrée de l'étage abaisseur de tension, et, d'autre part, le produit de la tension efficace aux bornes du réseau d'alimentation et la fréquence du réseau d'alimentation.

9. Véhicule automobile à traction au moins partiellement électrique, comprenant une machine électrique couplée à des roues motrices et un étage onduleur apte à alimenter la machine électrique à partir d'une batterie (2), **caractérisé en ce qu'**il comprend un dispositif (1) de charge de la batterie (2) selon l'une des revendications précédentes.

10. Procédé de commande d'un dispositif (1) de charge d'une batterie (2), notamment une batterie d'un véhicule automobile à traction électrique, à partir d'un réseau d'alimentation (3) triphasé ou monophasé, dans lequel on filtre au moins une tension d'entrée issue dudit réseau d'alimentation (3) à l'aide d'un étage de filtrage (5) comprenant un ensemble capacitif (5b), on mesure le courant d'alimentation en entrée ($B_1$, $B_2$, $B_3$) de l'étage de filtrage (5), on mesure la tension d'alimentation en entrée ($B_1$, $B_2$, $B_3$) de l'étage de filtrage (5), **caractérisé en ce que** l'on surveille l'état des condensateurs de l'ensemble capacitif (5b) à partir de la variation d'au moins un paramètre représentatif de l'ensemble capacitif (5b) à partir des tensions et des courants mesurés aux bornes d'entrée ($B_1$, $B_2$, $B_3$) de l'étage de filtrage (5).

11. Procédé selon la revendication 10, comprenant une détermination des valeurs efficaces des tensions et des courants mesurés, un calcul d'au moins un paramètre représentatif de l'ensemble capacitif à partir des valeurs efficaces de tension et de courant, et une détermination de l'état des condensateurs de l'ensemble capacitif (5b) à partir du paramètres représentatif calculé, et une délivrance d'un signal de commande pour limiter les performances de charge de la batterie et d'un signal d'avertissement de manière à avertir l'utilisateur de la dégradation de l'ensemble capacitif (5b).

12. Procédé selon la revendication 11, dans lequel la détermination de l'état des condensateurs de l'ensemble capacitif (5b) comprend au moins un calcul d'une valeur absolue de la différence entre une constante capacitive et le paramètre représentatif de l'ensemble capacitif (5b), et une comparaison de la valeur absolue calculée à un seuil de variation.

13. Procédé selon l'une des revendications 10 à 12, dans lequel le paramètre représentatif correspond, lorsque les moyens de surveillance sont activés avant le début de la charge de la batterie, au rapport entre la valeur du courant efficace d'une première phase et le produit de la fréquence avec la valeur de la tension efficace entre la première phase et une autre phase et, lorsque les moyens de surveillance sont activés après le début d'une charge sur un réseau monophasé, au rapport entre, d'une part, la différence entre deux fois le carré de la valeur efficace du courant d'alimentation et le carré de la valeur efficace du courant en entrée de l'étage abaisseur de tension et, d'autre part, le produit de la tension efficace aux bornes du réseau d'alimentation et la fréquence du réseau d'alimentation.

## Patentansprüche

1. Vorrichtung (1) zum Laden einer Batterie (2), insbesondere einer Batterie eines elektrisch betriebenen Kraftfahrzeugs, ausgehend von einem dreiphasigen oder einphasigen Versorgungsnetz (3), die eine Filterstufe (5) enthält, welche eine kapazitive Einheit (5b) aufweist und dazu bestimmt ist, an das Versorgungsnetz (3) angeschlossen zu werden, **dadurch gekennzeichnet, dass** sie Überwachungseinrichtungen (8) der kapazitiven Einheit (5b) enthält, die eine Abweichung des Werts der Kapazität mindestens eines Kondensators (C) der kapazitiven Einheit (5b) ausgehend von am Eingang ($B_1$, $B_2$, $B_3$) der Filterstufe (5) gemessenen Spannungen und Strömen erfassen können.

2. Vorrichtung nach Anspruch 1, die außerdem eine an die Filterstufe (5) angeschlossene Spannungsminderungsstufe (6) und eine Spannungserhöhungsstufe (7) aufweist, die dazu bestimmt ist, an die Batterie (2) angeschlossen und mit der Spannungsminderungsstufe (6) gekoppelt zu werden.

3. Vorrichtung (1) nach einem der Ansprüche 1 oder 2, **dadurch gekennzeichnet, dass** die Überwachungseinrichtungen (8) Einrichtungen (20) zur Bestimmung charakteristischer Werte der gemessenen Spannungen und Ströme, Berechnungseinrichtungen (21) mindestens eines für die kapazitive Einheit repräsentativen Parameters ausgehend von den charakteristischen Spannungs- und Stromwerten, Bestimmungseinrichtungen (22) des Zustands der Kondensatoren der kapazitiven Einheit (5b) ausgehend vom repräsentativen Parameter und Verarbeitungseinrichtungen (25) enthalten, die ein Steuersignal und/oder ein Warnsignal liefern können, um den Benutzer über die Verschlechterung der kapazitiven Einheit (5b) in Kenntnis zu setzen.

4. Vorrichtung nach Anspruch 3, wobei die charakteristischen Werte die Effektivwerte sind.

**5.** Vorrichtung nach einem der Ansprüche 3 oder 4, wobei das Steuersignal die Ladeleistungen der Batterie begrenzen kann.

**6.** Vorrichtung (1) nach einem der Ansprüche 3 bis 5, **dadurch gekennzeichnet, dass** die Bestimmungseinrichtungen (22) des Zustands der Kondensatoren mindestens ein Rechenmodul (23), das die Differenz zwischen dem repräsentativen Parameter und einer kapazitiven Konstante berechnen kann, und mindestens ein Vergleichsmodul (24) enthalten, das die berechnete Differenz mit einer Änderungsschwelle vergleichen kann.

**7.** Vorrichtung (1) nach einem der vorhergehenden Ansprüche, wobei die Überwachungseinrichtungen (8) Aktivierungseinrichtungen (19) enthalten, die die Überwachungseinrichtungen (8) aktivieren können, wenn die Vorrichtung (1) an das Versorgungsnetz (3) angeschlossen ist und vor dem Beginn des Ladens der Batterie (2), wobei der repräsentative Parameter, wenn die Überwachungseinrichtungen (8) vor dem Beginn des Ladens der Batterie (2) aktiviert werden, zum Verhältnis zwischen dem Wert des Effektivstroms einer ersten Phase und dem Produkt aus der Frequenz und dem Wert der Effektivspannung zwischen der ersten Phase und einer anderen Phase proportional ist.

**8.** Vorrichtung (1) nach einem der vorhergehenden Ansprüche, wobei die Überwachungseinrichtungen (8) Lade-Aktivierungseinrichtungen (26) enthalten, die die Überwachungseinrichtungen (8) aktivieren können, wenn die Batterie (2) an einem einphasigen Versorgungsnetz (3) geladen wird, wobei der repräsentative Parameter, wenn die Überwachungseinrichtungen (8) nach dem Beginn eines Ladens an einem einphasigen Versorgungsnetz (3) aktiviert werden, dem Verhältnis zwischen einerseits der Differenz zwischen dem Doppelten des Quadrats des Effektivwerts des Versorgungsstroms und dem Quadrat des Effektivwerts des Stroms am Eingang der Spannungsminderungsstufe und andererseits dem Produkt aus der Effektivspannung an den Klemmen des Versorgungsnetzes und der Frequenz des Versorgungsnetzes entspricht.

**9.** Zumindest teilweise elektrisch betriebenes Kraftfahrzeug, das eine mit Antriebsrädern gekoppelte elektrische Maschine und eine Wechselrichterstufe enthält, die die elektrische Maschine ausgehend von einer Batterie (2) versorgen kann, **dadurch gekennzeichnet, dass** es eine Vorrichtung (1) zum Laden der Batterie (2) nach einem der vorhergehenden Ansprüche enthält.

**10.** Steuerverfahren einer Vorrichtung (1) zum Laden einer Batterie (2), insbesondere einer Batterie eines elektrisch betriebenen Kraftfahrzeugs, ausgehend von einem dreiphasigen oder einphasigen Versorgungsnetz (3), wobei mindestens eine vom Versorgungsnetz (3) stammende Eingangsspannung mit Hilfe einer eine kapazitive Einheit (5b) enthaltenden Filterstufe (5) gefiltert wird, der Versorgungsstrom am Eingang ($B_1$, $B_2$, $B_3$) der Filterstufe (5) gemessen wird, die Versorgungsspannung am Eingang ($B_1$, $B_2$, $B_3$) der Filterstufe (5) gemessen wird, **dadurch gekennzeichnet, dass** der Zustand der Kondensatoren der kapazitiven Einheit (5b) ausgehend von der Änderung mindestens eines repräsentativen Parameters der kapazitiven Einheit (5b) ausgehend von den an den Eingangsklemmen ($B_1$, $B_2$, $B_3$) der Filterstufe (5) gemessenen Spannungen und Strömen überwacht wird.

**11.** Verfahren nach Anspruch 10, das eine Bestimmung der Effektivwerte der gemessenen Spannungen und Ströme, eine Berechnung mindestens eines repräsentativen Parameters der kapazitiven Einheit ausgehend von den Spannungs- und Strom-Effektivwerten und eine Bestimmung des Zustands der Kondensatoren der kapazitiven Einheit (5b) ausgehend vom berechneten repräsentativen Parameter und eine Lieferung eines Steuersignals, um die Ladeleistungen der Batterie zu begrenzen, und eines Warnsignals enthält, um den Benutzer über die Verschlechterung der kapazitiven Einheit (5b) in Kenntnis zu setzen.

**12.** Verfahren nach Anspruch 11, wobei die Bestimmung des Zustands der Kondensatoren der kapazitiven Einheit (5b) mindestens eine Berechnung eines Absolutwerts der Differenz zwischen einer kapazitiven Konstante und dem repräsentativen Parameter der kapazitiven Einheit (5b) und einen Vergleich des berechneten Absolutwerts mit einer Änderungsschwelle enthält.

**13.** Verfahren nach einem der Ansprüche 10 bis 12, wobei der repräsentative Parameter, wenn die Überwachungseinrichtungen vor dem Beginn des Ladens der Batterie aktiviert werden, dem Verhältnis zwischen dem Wert des Effektivstroms einer ersten Phase und dem Produkt aus der Frequenz und dem Wert der Effektivspannung zwischen der ersten Phase und einer anderen Phase entspricht, und wenn die Überwachungseinrichtungen nach dem Beginn eines Ladens an einem einphasigen Netz aktiviert werden, dem Verhältnis zwischen einerseits der Differenz zwischen dem Doppelten des Quadrats des Effektivwerts des Versorgungsstroms und dem Quadrat des Effektivwerts des Stroms am Eingang der Spannungsminderungsstufe und andererseits dem Produkt aus der Effektivspannung an den Klemmen des Versorgungsnetzes und der Frequenz des Versorgungsnetzes entspricht.

## Claims

1. Device (1) for charging a battery (2), notably a battery of a motor vehicle with electric traction, from a three-phase or single-phase power supply network (3), comprising a filtering stage (5) comprising a capacitive assembly (5b) and intended to be connected to the power supply network (3), **characterized in that** it comprises means (8) for monitoring the capacitive assembly (5b) capable of detecting a deviation in the capacitance value of at least one capacitor (C) of the capacitive assembly (5b) from voltages and currents measured at the input ($B_1$, $B_2$, $B_3$) of the filtering stage (5).

2. Device according to Claim 1, also comprising a buck stage (6) connected to the filtering stage (5), and a boost stage (7) intended to be connected to the battery (2) and coupled to the buck stage (6).

3. Device (1) according to one of Claims 1 or 2, **characterized in that** the monitoring means (8) comprise means (20) for determining characteristic values of the measured voltages and currents, means (21) for computing at least one parameter representative of the capacitive assembly from said voltage and current characteristic values, means (22) for determining the state of the capacitors of the capacitive assembly (5b) from the representative parameter, and processing means (25) suitable for delivering a control signal and/or a warning signal so as to alert the user to the degradation of the capacitive assembly (5b).

4. Device according to Claim 3, in which the characteristic values are the rms values.

5. Device according to one of Claims 3 or 4, in which the control signal is capable of limiting the battery charge performance levels.

6. Device (1) according to one of Claims 3 to 5, **characterized in that** the means (22) for determining the state of the capacitors comprise at least one computation module (23) capable of computing the difference between the representative parameter and the capacitive constant, and at least one comparison module (24) capable of comparing said computed difference with a variation threshold.

7. Device (1) according to one of the preceding claims, in which the monitoring means (8) comprise activation means (19) capable of activating the monitoring means (8) when the device (1) is connected to the power supply network (3) and before the start of the charging of the battery (2), the representative parameter being proportional, when the monitoring means (8) are activated before the start of the charging of the battery (2), to the ratio between the rms current value of a first phase and the product of the frequency with the value of the rms voltage between the first phase and another phase.

8. Device (1) according to one of the preceding claims, in which the monitoring means (8) comprise on-charge activation means (26) capable of activating the monitoring means (8) when the battery (2) is on charge on a single-phase power supply network (3), the representative parameter corresponding, when the monitoring means (8) are activated after the start of a charge on a single-phase power supply network (3), to the ratio between, on the one hand, the difference between twice the square of the rms value of the power supply current and the square of the rms value of the current at the input of the buck stage, and, on the other hand, the product of the rms voltage at the terminals of the power supply network and the frequency of the power supply network.

9. Motor vehicle with traction that is at least partially electrical, comprising an electrical machine coupled to drive wheels and an inverter stage capable of powering the electrical machine from a battery (2), **characterized in that** it comprises a device (1) for charging the battery (2) according to one of the preceding claims.

10. Method for controlling a device (1) for charging a battery (2), notably a battery of a motor vehicle with electric traction, from a three-phase or single-phase power supply network (3), in which at least one input voltage from said power supply network (3) is filtered using a filtering stage (5) comprising a capacitive assembly (5b), the power supply current at the input ($B_1$, $B_2$, $B_3$) of the filtering stage (5) is measured, and the power supply voltage at the input ($B_1$, $B_2$, $B_3$) of the filtering stage (5) is measured, **characterized in that** the state of the capacitors of the capacitive assembly (5b) is monitored on the basis of the variation of at least one parameter representative of the capacitive assembly (5b) from the voltages and currents measured at the input terminals ($B_1$, $B_2$, $B_3$) of the filtering stage (5).

**11.** Method according to Claim 10, comprising a determination of the rms values of the measured voltages and currents, a computation of at least one parameter representative of the capacitive assembly from the rms voltage and current values, and a determination of the state of the capacitors of the capacitive assembly (5b) from the computed representative parameters, and a delivery of a control signal to limit the battery charge performance levels and of a warning signal so as to alert the user to the degradation of the capacitive assembly (5b).

**12.** Method according to Claim 11, in which the determination of the state of the capacitors of the capacitive assembly (5b) comprises at least one computation of an absolute value of the difference between a capacitive constant and the parameter representative of the capacitive assembly (5b), and a comparison of the computed absolute value with a variation threshold.

**13.** Method according to one of Claims 10 to 12, in which the representative parameter corresponds, when the monitoring means are activated before the start of the charging of the battery, to the ratio between the value of the rms current of a first phase and the product of the frequency with the value of the rms voltage between the first phase and another phase, and, when the monitoring means are activated after the start of a charge on a single-phase network, to the ratio between, on the one hand, the difference between twice the square of the rms value of the power supply current and the square of the rms value of the current at the input of the buck stage, and, on the other hand the product of the rms voltage at the terminals of the power supply network and the frequency of the power supply network.

# FIG.1

FIG.2

## FIG.3

## FIG.4

**EP 2 755 848 B1**

## RÉFÉRENCES CITÉES DANS LA DESCRIPTION

**Documents brevets cités dans la description**

- FR 2943188
- US 4419621 A
- US 5880589 A
- US 20100321038 A